**Europäisches Patentamt**

**European Patent Office**

**Office européen des brevets**

(19)

(11) Veröffentlichungsnummer: **0 106 204**
**B1**

(12)

# EUROPÄISCHE PATENTSCHRIFT

(45) Veröffentlichungstag der Patentschrift:
**24.06.87**

(51) Int. Cl.⁴: **G 01 R 33/06**

(21) Anmeldenummer: **83109382.8**

(22) Anmeldetag: **21.09.83**

(54) **Schaltung mit Hall-Feldsonde.**

(30) Priorität: **23.09.82 DE 3235188**

(43) Veröffentlichungstag der Anmeldung:
**25.04.84 Patentblatt 84/17**

(45) Bekanntmachung des Hinweises auf die Patenterteilung:
**24.06.87 Patentblatt 87/26**

(84) Benannte Vertragsstaaten:
**CH FR GB LI**

(56) Entgegenhaltungen:
**EP - A - 0 052 981**
**DE - A - 2 640 082**
**GB - A - 797 505**

(73) Patentinhaber: **Kernforschungsanlage Jülich Gesellschaft mit beschränkter Haftung, Postfach 1913, D-5170 Jülich 1 (DE)**

(72) Erfinder: **Eulenberg, Hannspeter, Dr., Georgstrasse 33, D-5100 Aachen (DE)**

## Beschreibung

Die Erfindung bezieht sich auf eine Schaltung mit Hall-Feldsonde zur Messung der magnetischen Induktion über die Hall-Spannung, wobei die Hall-Feldsonde einen Temperaturkoeffizienten des Widerstandes des Steuerstrompfades aufweist, wobei dem Steuerstrompfad der Hall-Feldsonde ein einstellbarer, praktisch temperaturunabhängiger Vorwiderstand vorgeschaltet und ein Operationsverstärker vorgesehen ist, an dessen Eingängen eine Spannung leistungslos eingekoppelt ist und durch die ein durch die Temperatur der Feldsonde bedingter Korrekturstrom zur Kompensation des temperaturabhängigen Teils der Hall-Spannung erzeugt wird.

Es ist bekannt, bei Hall-Feldsonden mit negativem Temperaturkoeffizienten zur Kompensation dieser Temperaturdrift der Hall-Spannung einen mit der Feldsonde und einem Vorwiderstand in Reihe geschalteten Konstantspannungsgenerator vorzusehen. Der hierdurch in der Feldsonde fliessende Steuerstrom nimmt mit steigender Temperatur der Sonde wegen des negativen Temperaturkoeffizienten des Steuerstrompfad-Widerstandes zu. Der bei steigenden Temperaturen in der Feldsonde verursachten Abnahme der Hall-Spannung wird dadurch entgegengewirkt.

Die bei dieser bekannten Schaltung erzielte Verbesserung liegt jedoch allein in der Kompensation der Temperaturdrift der Hall-Spannung. Eine weitere Ausgestaltung, beispielsweise zur Linearisierung der Kennlinie der Hall-Feldsonde, ermöglicht diese bekannte Schaltung jedoch nicht.

Es ist Aufgabe der Erfindung, eine Schaltung zu schaffen, die bei einer Hall-Feldsonde mit negativem Temperaturkoeffizienten zu einer Kompensation der Temperaturdrift der Hall-Spannung führt, darüberhinaus im weiteren Ausbau aber auch eine Kompensation weiterer, der Hall-Spannung überlagerter Störspannungen ermöglicht.

Die der Erfindung zugrundeliegende Aufgabe wird bei einer Schaltung der eingangs bezeichneten Art dadurch gelöst, dass zur Kompensation der Temperaturdrift der Hall-Spannung einer Hall-Feldsonde mit negativem Temperaturkoeffizienten (TK) des Widerstandes des Steuerstrompfades (1–1') der Operationsverstärker mit seinem invertierenden Eingang mit einem der Signalspannungskontakte der Feldsonde verbunden ist, an dessen nichtinvertierendem Eingang gegen Masse eine Gleich- oder Wechselspannung konstanter Amplitude leistungslos eingekoppelt ist, durch die ein durch die Feldsonde fliessender Steuerstrom erzeugt wird, dessen Grösse durch die eingekoppelte Spannung, den Vorwiderstand und den durch die Lage der Signalspannungskontakte bedingten eingangsseitigen Teilwiderstand des Steuerstrompfades der Feldsonde bestimmt ist, dass der Operationsverstärker ausgangsseitig mit dem ausgangsseitigen Steuerstromanschluss der Feldsonde verbunden ist und wobei die durch eine Temperaturänderung in der Feldsonde bewirkte Änderung des Steuerstromes der Korrekturstrom ist, der bei entsprechend abgeglichenem Vorwiderstand den temperaturabhängigen Anteil der Hall-Spannung kompensiert.

Wie bei der eingangs angegebenen bekannten Schaltung nimmt auch bei der Schaltung gemäss der Erfindung der Steuerstrom in der Sonde bei steigenden Temperaturen in der Sonde zu, wobei jedoch eine leistungslose Einkoppelung der den Steuerstrom erzeugenden Spannung bei der Schaltung gemäss der Erfindung erfolgt und der Steuerstrom nur durch einen Teilwiderstand der Feldsonde mitbestimmt ist. Durch die Änderung des Steuerstromes, den Korrekturstrom, wird der bei steigenden Temperaturen verursachten Abnahme der Hall-Spannung entgegengewirkt. Bei entsprechender Dimensionierung des Vorwiderstandes wird somit in dem Temperaturbereich, in dem die Hall-Spannung proportional zum Widerstand des Steuerstrompfades ist, der Temperatureinfluss auf die Hall-Spannung in der am Schaltungsausgang anstehenden Spannung kompensiert.

Aus der DE-A-2 640 082 ist eine Schaltung bekannt, bei der ebenso wie bei der Schaltung gemäss der Erfindung die temperaturabhängige Hall-Spannung mittels eines von der Temperatur der Feldsonde abhängigen Korrekturstromes ausgeglichen wird, wobei als Temperaturfühler quasi der Steuerstrompfad der Feldsonde dient. Diese bekannte Schaltung unterscheidet sich jedoch – ganz abgesehen davon, dass sie eine Hall-Feldsonde mit positivem Temperaturkoeffizienten betrifft – von der Schaltung gemäss der Erfindung in wesentlichen Merkmalen. So handelt es sich bei der bekannten Schaltung – anders als bei der Schaltung gemäss der Erfindung – um eine sich selbst abgleichende Brückenschaltung. Der in der bekannten Schaltung vorgesehene Operationsverstärker wird dabei als Differenzverstärker zum automatischen Abgleich der Brücke verwendet, wogegen der in der Schaltung gemäss der Erfindung vorgesehene Operationsverstärker als solcher eingesetzt wird und gleichzeitig als Steuerstromgenerator wirkt. Der Steuerstrom wird dagegen bei der bekannten Schaltung von einem nicht in die Schaltung integrierten Generator erzeugt. Bei der bekannten Schaltung ist ausserdem die Feldsonde nicht in die Schaltung selbst integriert. Ein weiterer Ausbau der bekannten Schaltung zur Kompensation weiterer Störgrössen ist ebenfalls nicht möglich.

Die Schaltung gemäss der Erfindung ist, ohne dass weitere Massnahmen erforderlich wären, bei Messung kleiner magnetischer Wechselfelder mit hinreichender Genauigkeit einsetzbar. Dabei wird zweckmässig als einzukoppelnde Spannung eine Wechselspannung vorgesehen, die vorzugsweise eine höhere Frequenz als das magnetische Wechselfeld aufweist, um die Hall-Spannung frequenzselektiv messen zu können. Auf diese Weise ist die Schaltung gemäss der Erfindung anwendbar, ohne dass beispielsweise eine Kompensation der Ohm'schen Nullspannung erforderlich wäre.

Im Hinblick auf eine einwandfreie Kompensation des temperaturabhängigen Anteils der Hall- Spannung hat sich als zweckmässig erwiesen, dass als Zuleitungsdrähte für den Steuerstrompfad der Feldsonde Drähte aus im Widerstand praktisch temperaturunabhängigem Material wie Manganin oder Konstantan vorgesehen sind.

Eine zweckmässige weitere Ausgestaltung der Schaltung gemäss der Erfindung besteht darin, dass zur Unterdrückung der zur Erzeugung des Steuerstromes eingekoppelten Spannung in der zwischen Masse und dem zweiten Signalspannungskontakt der Feldsonde anstehenden Spannung ein in seiner Differenzbildung einstellbarer Differenzverstärker vorgesehen ist, der mit seinem einen Eingang mit dem zweiten Signalspannungskontakt der Feldsonde und mit seinem zweiten Eingang mit dem ausgangsseitigen Steuerstromanschluss der Feldsonde und wahlweise mit dem Ausgang des Operationsverstärkers oder mit dessen nicht invertierendem Eingang verbunden ist, wobei die Ausgangsspannung des Differenzverstärkers der temperaturkompensierten Hall-Spannung entspricht. Damit ist der durch die eingekoppelte Spannung bedingte Grundpegel beseitigt, wodurch auch eine hinreichend genaue Messung der Induktion kleiner magnetischer Felder über die Hall-Spannung bei eingekoppelter Gleichspannung möglich ist.

Aus fertigungstechnischen Gründen kann das Auftreten der sog. Ohm'schen Nullspannung praktisch nicht vermieden werden. Diese Nullspannung ist – wenn keine Massnahmen zur Kompensation dieser Spannung vorgesehen werden – der Hallspannung und damit der am Ausgang des Differenzverstärkers anstehenden Spannung überlagert. Eine vorteilhafte Weiterausgestaltung der Schaltung gemäss der Erfindung, bei der ein Differenzverstärker zur Unterdrückung der eingekoppelten Spannung vorgesehen ist, besteht darin, dass zur Kompensation der Nullspannung der Feldsonde ein zwischen dem ausgangsseitigen Steuerstromanschluss der Feldsonde und dem Ausgang des Operationsverstärkers liegender, einstellbarer, praktisch temperaturunabhängiger Widerstand vorgesehen ist, wobei der zweite Eingang des Differenzverstärkers mit dem Ausgang des Operationsverstärkers verbunden ist.

Der einstellbare Widerstand beeinflusst nicht die Grösse des Steuerstromes. Er kann dazu benutzt werden, die Grösse einer temperaturabhängigen Spannung einzustellen, die vom Ausgang eines Operationsverstärkers dem zweiten Eingang des Differenzverstärkers zugeführt wird. Durch entsprechende Dimensionierung des einstellbaren Widerstandes wird so die Ohm'sche Nullspannung unterdrückt.

Die Kompensation des temperaturabhängigen Teils der Nullspannung wird durch entsprechende Einstellung des Differenzverstärkers vorgenommen. Für diesen Fall hat sich als zweckmässig erwiesen, dass als Differenzverstärker ein Operationsverstärker mit Trimmer vorgesehen ist, wobei der nicht invertierende Eingang dieses zweiten Operationsverstärkers mit dem zweiten Signalspannungskontakt und der invertierende Eingang mit dem Schleifer des Trimmers verbunden ist und wobei einer der beiden anderen Anschlüsse des Trimmers mit dem Ausgang des zweiten Operationsverstärkers und der weitere Anschluss mit dem Ausgang des ersten Operationsverstärkers verbunden ist.

Zwischen dem eingangsseitigen Steuerstromanschluss der Feldsonde und dem mit dem ersten Operationsverstärker in Verbindung stehenden Signalspannungskontakt liegt ein Teil der vom zu messenden Magnetfeld erzeugten Hall-Spannung (bei einer symmetrisch aufgebauten Hall-Feldsonde ist es die halbe Hall-Spannung). Dieser Teil der Hall-Spannung erzeugt einen Steuerstromanteil, der nicht nur durch die Temperatur in der Feldsonde, sondern auch vom zu messenden Magnetfeld beeinflusst wird. Dadurch entsteht zunächst eine Verstärkung der in der Kennlinie der Feldsonde an sich durch den Umkehreffekt schon vorhandenen Krümmung. Zur Beseitigung dieses störenden Effektes ist eine weitere vorteilhafte Ausführungsform der Schaltung gemäss der Erfindung vorgesehen, die darin besteht, dass zur Kompensation dieses zwischen dem Eingangsseitigen Steuerstromanschluss der Feldsonde und dem mit dem ersten Operationsverstärker in Verbindung stehenden Signalspannungskontakt liegenden Teil der Hall-Spannung ein Summierer dem nicht invertierenden Eingang des ersten Operationsverstärkers vorgeschaltet ist, wobei der Eingang des Summierers mit dem Ausgang der Schaltung verbunden ist, und am anderen Eingang die einzukoppelnde Spannung anliegt. Über das Summierglied wird gegenphasig zur Hall-Spannung ein Teil der am Ausgang der Schaltung anliegenden Spannung gegengekoppelt, womit auch der durch den Umkehreffekt in der Messspannung bedingte Linearitätsfehler der Kennlinie kompensiert wird.

Je nach der verwendeten Ausführungsform der Schaltung gemäss der Erfindung wird somit für die Messung der Induktion über die Hall-Spannung die Nachweisgrenze der Induktion herabgesetzt und insgesamt – auch bei grösseren Werten der Induktion – die Messgenauigkeit verbessert. Die Schaltung gemäss der Erfindung ermöglicht somit auch solche Feldsonden für genaue Messungen einzusetzen, die empfindlich sind, aber einen grossen negativen Temperaturkoeffizienten aufweisen.

Verschiedene Ausführungsformen der Schaltung gemäss der Erfindung werden in der Zeichnung dargestellt und im folgenden näher erläutert:

Es zeigen

Fig. 1 Schaltung mit Feldsonde zur Kompensation des temperaturabhängigen Teils der Hall-Spannung

Fig. 2 Schaltung mit Feldsonde gemäss Fig. 1 mit Schaltungsteil zur Unterdrückung der eingekoppelten Spannung $u_S$ bzw. $U_S$

Fig. 3 Schaltung mit Feldsonde gemäss Fig. 2 mit Schaltungsteil zur Unterdrückung der Nullspannung und zur Kompensation des temperaturabhängigen Teils der Nullspannung

Fig. 4 Schaltung mit Feldsonde gemäss Fig. 3 mit Ausführungsform des Differenzverstärkers und Schaltungsteil zur Linearisierung der Kennlinie der Feldsonde

Fig. 5 konkrete Ausführungsform der in Fig. 4 dargestellten Schaltung.

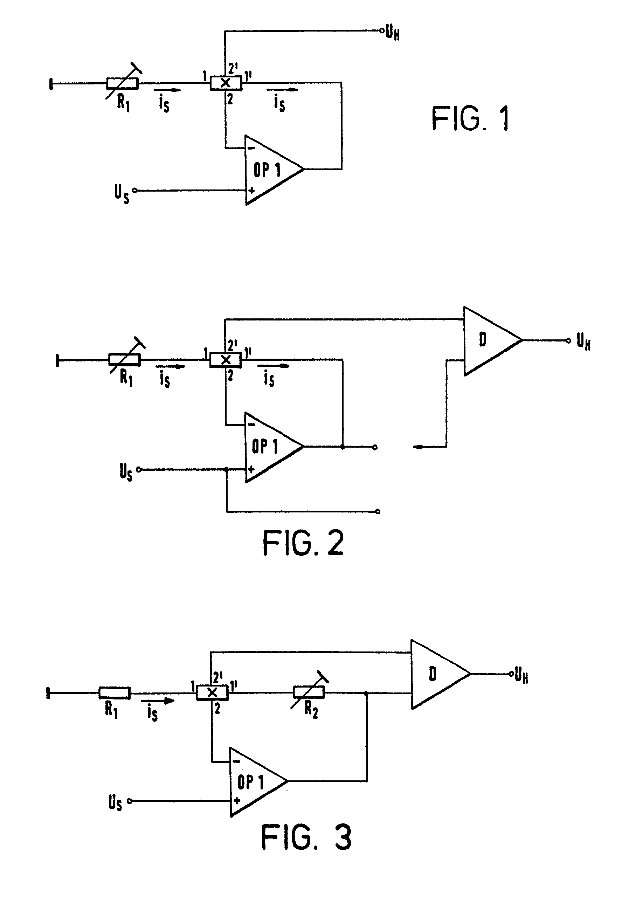

Wie aus Fig. 1 hervorgeht, ist dem Steuerstrompfad 1–1' der Hall-Feldsonde der einstellbare Vorwiderstand $R_1$ vorgeschaltet und der Operationsverstärker $OP_1$ mit seinem invertierenden Eingang mit dem Signalspannungskontakt 2 der Feldsonde verbunden. Durch die am nicht invertierenden Eingang des Operationsverstärkers $OP_1$ gegen Masse liegende Wechselspannung $u_S$ wird ein durch die Feldsonde fliessender Steuerstrom $i_S$ erzeugt, dessen Grösse bei fehlender Induktion durch die eingekoppelte Wechselspannung $u_S$, den Vorwiderstand $R_1$ und den durch die Lage der Signalspannungskontakte 2–2' (im in der Zeichnung dargestellten Fall sind die Signalspannungskontakte spiegelsymmetrisch zur Mittelpunktsachse angeordnet) bedingten eingangsseitigen Teilwiderstand des Steuerstrompfades der Feldsonde bestimmt ist. Die durch eine Temperaturänderung in der Feldsonde bewirkte Änderung des Steuerstromes ist gegenläufig zur Auswirkung der Temperaturänderung auf die Hall-Spannung, so dass der temperaturabhängige Anteil der Hall-Spannung bei entsprechend abgeglichenen Vorwiderstand $R_1$ hierdurch kompensiert wird.

Fig. 2 zeigt eine Ausführungsform der Schaltung, in der – ausgehend von der in Fig. 1 dargestellten Schaltung – zusätzlich ein in seiner Differenzbildung einstellbarer Differenzverstärker D vorgesehen ist. Er dient dazu, die eingekoppelte Spannung $u_S$ in der Ausgangsspannung $u_H$ zu unterdrücken. Der Differenzverstärker D kann dazu, wie aus Fig. 2 zu ersehen ist, mit einem seiner Eingänge wahlweise mit dem Ausgang des Operationsverstärkers $OP_1$ oder mit dessen nicht invertierenden Eingang verbunden sein.

In der in Fig. 3 dargestellten Ausführungsform der Schaltung ist – ausgehend von der Schaltung gemäss Fig. 2 – zusätzlich der einstellbare Widerstand $R_2$ zwischen dem ausgangsseitigen Steuerstromanschluss 1' der Feldsonde und dem Ausgang des Operationsverstärkers $OP_1$ vorgesehen. Einer der beiden Eingänge des Differenzverstärkers D ist dabei mit dem ausgangsseitigen Anschluss des Widerstandes $R_2$ und mit dem Ausgang des Operationsverstärkers $OP_1$ verbunden. Durch entsprechenden Abgleich des Widerstandes $R_2$ wird dem Differenzverstärker D eine der Nullspannung entsprechende Spannung zugeführt, wobei diese in der Ausgangsspannung unterdrückt wird. Durch Einstellung des Differenzverstärkers wird bei dieser Schaltungsausführung der temperaturabhängige Teil der Nullspannung kompensiert.

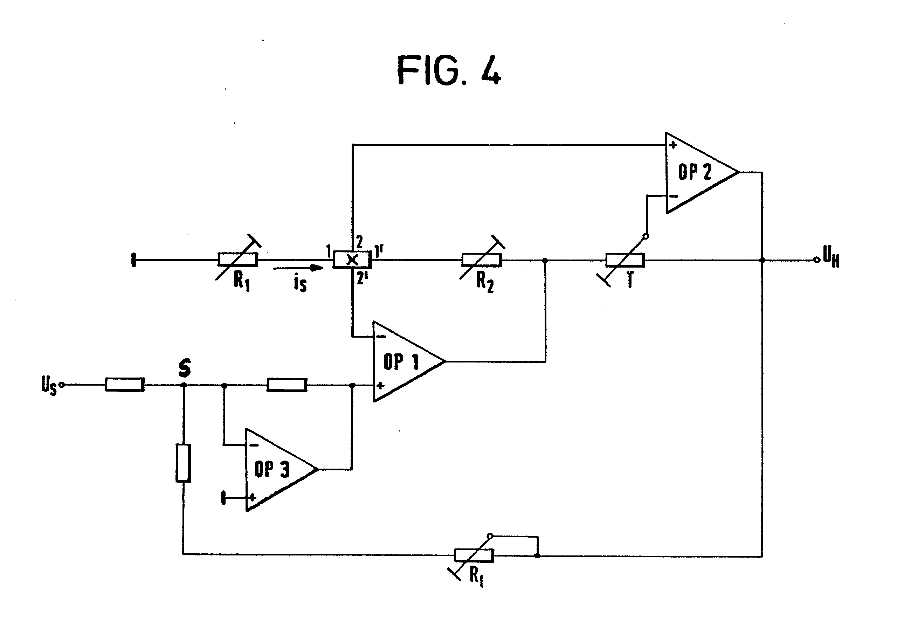

Fig. 4 zeigt eine zweckmässige Ausgestaltung des Differenzverstärkers D der in Fig. 3 dargestellten Schaltungsausführung. Er besteht aus dem Operationsverstärker $OP_2$ und dem vorgeschalteten Trimmer T, der – nach entsprechendem Abgleich von $R_2$ – zur Kompensation des temperaturabhängigen Teils der Nullspannung abgeglichen wird.

Aus Fig. 4 ist ausserdem ein zusätzlicher Schaltungsteil zur Kompensation der durch den Umkehreffekt in der Messspannung bedingten Nichtlinearität der Kennlinie der Feldsonde zu ersehen. Er besteht in dem in der dargestellten Weise verschalteten Summierer S. Dadurch wird ein Teil der Spannung $u_H$, die am Ausgang der Schaltung anliegt, gegenphasig zur Hall-Spannung gegengekoppelt. Der entsprechende Abgleich geschieht dabei durch Einstellen des Widerstandes $R_L$.

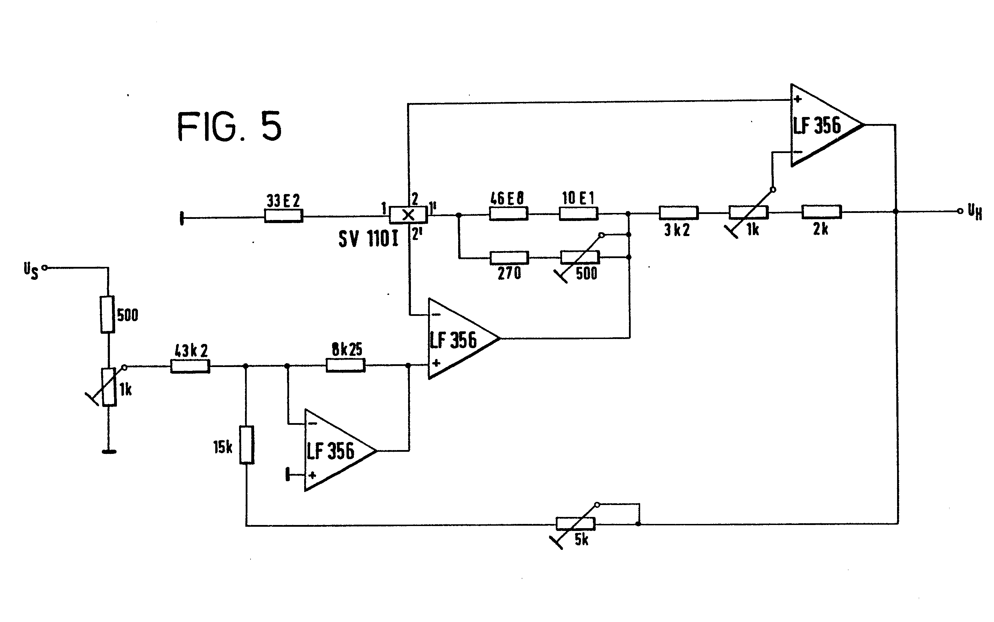

In Fig. 5 ist eine konkrete Ausführungsform der in Fig. 4 dargestellten Schaltung wiedergegeben. Die Widerstandswerte, die verwendeten Verstärker sowie die verwendete Hall-Feldsonde sind den beigefügten Zahlenangaben bzw. den Typenbezeichnungen zu entnehmen.

**Patentansprüche**

1. Schaltung mit Hall-Feldsonde zur Messung der magnetischen Induktion über die Hall-Spannung, wobei die Hall-Feldsonde einen Temperaturkoeffizienten (TK) des Widerstandes des Steuerstrompfades (1–1') aufweist, wobei dem Steuerstrompfad (1–1') der Hall-Feldsonde ein einstellbarer, praktisch temperaturunabhängiger Vorwiderstand ($R_1$) vorgeschaltet und ein Operationsverstärker ($OP_1$) vorgesehen ist, an dessen Eingängen eine Spannung leistungslos eingekoppelt ist und durch die ein durch die Temperatur der Feldsonde bedingter Korrekturstrom zur Kompensation des temperaturabhängigen Teils der Hall-Spannung erzeugt wird, dadurch gekennzeichnet, dass zur Kompensation der Temperaturdrift der Hall-Spannung einer Hall-Feldsonde mit negativem Temperaturkoeffizienten (TK) des Widerstandes des Steuerstrompfades (1–1') der Operationsverstärker ($OP_1$) mit seinem invertierenden Eingang mit einem der Signalspannungskontakte (2) der Feldsonde verbunden ist, an dessen nichtinvertierendem Eingang gegen Masse eine Gleich- oder Wechselspannung ($U_S$ bzw. $u_s$) konstanter Amplitude leistungslos eingekoppelt ist, durch die ein durch die Feldsonde fliessender Steuerstrom ($i_S$ bzw. $I_S$) erzeugt wird, dessen Grösse durch die eingekoppelte Spannung, den Vorwiderstand ($R_1$) und den durch die Lage der Signalspannungskontakte (2, 2') bedingten eingangsseitigen Teilwiderstand des Steuerstrompfades der Feldsonde bestimmt ist, dass der Operationsverstärker ($OP_1$) ausgangsseitig mit dem ausgangsseitigen Steuerstromanschluss (1') der Feldsonde verbunden ist und wobei die durch eine Temperaturänderung in der Feldsonde bewirkte Änderung des Steuerstromes der Korrekturstrom ist, der bei entsprechend abgeglichenem Vorwiderstand den temperaturabhängigen Anteil der Hall-Spannung kompensiert.

2. Schaltung nach Anspruch 1, dadurch gekennzeichnet, dass als Zuleitungsdrähte für den Steuerstrompfad (1–1') der Feldsonde Drähte aus im Widerstand praktisch temperaturunabhängigem Material, wie Manganin oder Konstantan, vorgesehen sind.

3. Schaltung nach Anspruch 1 oder 2, dadurch gekennzeichnet, dass zur Unterdrückung der zur

Erzeugung des Steuerstromes ($i_S$ bzw. $I_S$) einge-koppelten Spannung ($u_S$ bzw. $U_S$) in der zwischen Masse und dem zweiten Signalspannungskontakt (2') der Feldsonde anstehenden Spannung ein in seiner Differenzbildung einstellbarer Differenzverstärker (D) vorgesehen ist, der mit seinem einen Eingang mit dem zweiten Signalspannungskontakt (2') der Feldsonde und mit seinem zweiten Eingang mit dem ausgangsseitigen Steuerstromanschluss (1') der Feldsonde und wahlweise mit dem Ausgang des Operationsverstärkers ($OP_1$) oder mit dessen nichtinvertierendem Eingang verbunden ist, wobei die Ausgangsspannung des Differenzverstärkers der temperaturkompensierten Hall-Spannung ($u_H$ bzw. $U_H$) entspricht.

4. Schaltung nach Anspruch 3, dadurch gekennzeichnet, dass zur Kompensation der Nullspannung der Feldsonde ein zwischen dem ausgangsseitigen Steuerstromanschluss (1') der Feldsonde und dem Ausgang des Operationsverstärkers ($OP_1$) liegender, einstellbarer, praktisch tempera-turunabhängiger Widerstand ($R_2$) vorgesehen ist, wobei der zweite Eingang des Differenzverstärkers (D) mit dem Ausgang des Operationsverstär-kers ($OP_1$) verbunden ist.

5. Schaltung nach Anspruch 3 oder 5, dadurch gekennzeichnet, dass als Differenzverstärker ein Operationsverstärker ($OP_2$) mit Trimmer (T) vor-gesehen ist, wobei der nichtinvertierende Eingang dieses zweiten Operationsverstärkers mit dem zweiten Signalspannungskontakt (2') und der invertierende Eingang mit dem Schleifer des Trimmers (T) verbunden ist und wobei einer der beiden anderen Anschlüsse des Trimmers mit dem Aus-gang des zweiten Operationsverstärkers ($OP_2$) und der weitere Anschluss mit dem Ausgang des ersten Operationsverstärkers ($OP_1$) verbunden ist.

6. Schaltung nach einem der vorhergehenden Ansprüche, dadurch gekennzeichnet, dass zur Kompensation des zwischen dem eingangsseitigen Steuerstromanschluss (1) der Feldsonde und dem mit dem ersten Operationsverstärker ($OP_1$) in Verbindung stehenden Signalspannungskontakt (2') liegenden Teils der Hall-Spannung ein Summierer (S) dem nichtinvertierenden Eingang des ersten Operationsverstärkers ($OP_1$) vorgeschaltet ist, wobei der Eingang des Summierers mit dem Ausgang der Schaltung verbunden ist, und am anderen Eingang die einzukoppelnde Spannung ($u_S$ bzw. $U_S$) anliegt.

**Claims**

1. Circuit with Hall field probe for measuring the magnetic induction by means of the Hall voltage, the Hall field probe having a temperature coefficient (TK) of the resistance of the control current path (1–1'), the control current path (1–1') of the Hall field probe being preceded by an adjustable, substantially temperature-independent, series re-sistor ($R_1$), and there being provided an operation-al amplifier ($OP_1$) to whose inputs a voltage is coupled-in in wattless manner, and whereby a correction current is produced, dependent on the temperature of the field probe, for compensation of the temperature-dependent part of the Hall voltage, characterised in that for compensation of the temperature drift of the Hall voltage of a Hall field probe with negative temperature coefficient (TK) of the resistance of the control current path (1–1'), the operational amplifier ($OP_1$) is connected with its inverting input to one of the signal voltage contacts (2) of the field probe, there being coupled-in in wattless manner to its non-inverting input to earth a DC or AC voltage ($U_S$ or $u_s$) of constant amplitude whereby a control current ($i_S$ or $I_S$) flowing through the field probe is produced, the magnitude of this current being determined by the coupled-in voltage, the series resistor ($R_1$) and the input-side partial resistance of the control path of the field probe, which partial resistance is dependent on the position of the signal voltage contacts (2, 2'), and that the operational amplifier ($OP_1$) is connected at the output side to the output-side control current terminal (1') of the field probe, and the variation of the control current effected by a temperature variation in the field probe is the correction current which, with the series resistor appropriately balanced, compensates for the temperature-dependent part of the Hall voltage.

2. Circuit according to claim 1, characterised in that wires made of material substantially independent of temperature in its resistance, such as manganin or constantan, are used as supply wires for the control current path (1–1') of the field probe.

3. Circuit according to claim 1 or 2, characterised in that for suppressing the voltage ($u_s$ or $U_S$) coupled-in for producing the control current ($i_S$ or $I_S$) in the voltage occurring between earth and the second signal voltage contact (2') of the field probe there is provided a differential amplifier (D) which is adjustable in its subtraction and which is connected with one of its inputs to the second signal voltage contact (2') of the field probe and with its second input to the output-side control current terminal (1') of the field probe and, selectively, to the output of the operational amplifier ($OP_1$) or to its non-inverting input, the output voltage of the differential amplifier corresponding to the temperature-compensated Hall voltage ($u_H$ or $U_H$).

4. Circuit according to claim 3, characterised in that for compensation for the zero voltage of the field probe there is provided an adjustable sub-stantially temperature-independent resistor ($R_2$) which is situated between the output-side control current terminal (1') of the field probe and the output of the operational amplifier ($OP_1$), the second input of the differential amplifier (D) being connected to the output of the operational am-plifier ($OP_1$).

5. Circuit according to claim 3 or 5, characterised in that as differential amplifier there is provided an operational amplifier ($OP_2$) with trim-mer (T), the non-inverting input of this second operational amplifier being connected to the second signal voltage contact (2'), and the inverting input being connected to the slide of the trimmer (T), one of the two other terminals of the trimmer being connected to the output of the

second operational amplifier (OP$_2$) and the further terminal being connected to the output of the first operational amplifier (OP$_1$).

6. Circuit according to one of the preceding claims, characterised in that for compensation for that part of the Hall voltage which is located between the input-side control current terminal (1) of the field probe and the signal voltage contact (2') connected to the first operational amplifier (OP$_1$), a summer (S) precedes the non-inverting input of the first operational amplifier (OP$_1$), the input of the summer being connected to the output of the circuit, and the voltage (u$_S$ or U$_S$) to be coupled-in is present at the other input.

## Revendications

1. Circuit avec une sonde de champs Hall pour mesurer l'induction magnétique par la tension de Hall, dans lequel la sonde de champ Hall présente un coefficient de température (TK) de la résistance du trajet (1–1') du courant de commande, le trajet (1–1') du courant de commande de la sonde étant précédé d'une résistance additionnelle réglable (R$_1$), pratiquement indépendante de la température, et dans lequel est prévu un amplificateur opérationnel (OP$_1$), aux entrées duquel une tension est injectée sans absorption de puissance et par lequel est produit un courant de correction, découlant de la température de la sonde, pour la compensation de la partie dépendante de la température de la tension de Hall, caractérisé en ce que, pour compenser la dérive de la tension de Hall sous l'influence de la température d'une sonde de champs Hall à coefficient de température (TK) négatif de la résistance du trajet (1–1') du courant de commande, l'amplificateur opérationnel (OP$_1$) est relié par son entrée inverseuse à l'un des contacts de tension de signal (2) de la sonde, amplificateur à l'entrée non inverseuse duquel une tension continue ou alternative (U$_S$ ou u$_S$), d'amplitude constante, est injectée, par rapport à la masse et sans absorption de puissance, tension qui produit un courant de commande (i$_S$ ou I$_S$), parcourant la sonde, dont l'intensité est déterminée par la tension injectée, la résistance additionnelle (R$_1$) et la résistance partielle côté entrée du trajet du courant de commande de la sonde, résistance partielle qui découle de la position des contacts de tension de signal (2, 2'), et que la sortie de l'amplificateur opérationnel (OP$_1$) est reliée à la connexion côté sortie (1') pour le courant de commande de la sonde, la variation du courant de commande, produite par un changement de température dans la sonde, étant le courant de correction qui, lorsque la résistance additionnelle est ajustée en conséquence, compense la partie dépendante de la température de la tension de Hall.

2. Circuit selon la revendication 1, caractérisé en ce que les fils de connexion pour le trajet (1–1') du courant de commande de la sonde de champs sont des fils d'un matériau, tel que manganine ou constantan, dont la résistivité est pratiquement indépendante de la température.

3. Circuit selon la revendication 1 ou 2, caractérisé en ce que, dans le but de supprimer la tension injectée (u$_S$ ou U$_S$), pour produire le courant de commande (i$_S$ ou I$_S$), dans la tension apparaissant entre la masse et le second contact de tension de signal (2') de la sonde de champs, on a prévu un amplificateur différenciateur (D) dont la formation de la différence est réglable et qui est relié par l'une de ses entrées au second contact de tension de signal (2') de la sonde et par sa seconde entrée à la connexion côté sortie (1') du trajet du courant de commande de la sonde et, au choix, à la sortie de l'amplificateur opérationnel (OP$_1$) ou à son entrée non inverseuse, la tension de sortie de l'amplificateur différenciateur correspondant à la tension de Hall (u$_H$ ou U$_H$) compensée en température.

4. Circuit selon la revendication 3, caractérisé en ce que, pour compenser la tension nulle de la sonde de champs, on a prévu une résistance réglable (R$_2$), pratiquement indépendante de la température, entre la connexion côté sortie (1') pour le courant de commande de la sonde et la sortie de l'amplificateur opérationnel (OP$_1$), la seconde entrée de l'amplificateur différenciateur (D) étant reliée à la sortie de l'amplificateur opérationnel (OP$_1$).

5. Circuit selon la revendication 3 ou 4, caractérisé en ce que, en tant qu'amplificateur différenciateur, on a prévu un amplificateur opérationnel (OP$_2$) avec un potentiomètre d'ajustement (T), l'entrée non inverseuse de ce second amplificateur opérationnel étant reliée au second contact de tension de signal (2'), l'entrée inverseuse étant reliée au curseur du potentiomètre (T), l'une des deux autres bornes du potentiomètre étant reliée à la sortie du second amplificateur opérationnel (OP$_2$) et l'autre borne étant reliée à la sortie du premier amplificateur opérationnel (OP$_1$).

6. Circuit selon une des revendications précédentes, caractérisé en ce que, pour compenser la partie de la tension de Hall apparaissant entre la connexion côté entrée (1) pour le courant de commande de la sonde de champs et le contact de tension de signal (2') en liaison avec le premier amplificateur opérationnel (OP$_1$), un totalisateur (S) est prévu en amont de l'entrée non inverseuse du premier amplificateur opérationnel (OP$_1$), l'entrée du totalisateur étant reliée à la sortie du circuit et la tension (u$_S$ ou U$_S$) à injecter étant appliquée à l'autre entrée.

FIG. 1

FIG. 2

FIG. 3

FIG. 4

FIG. 5